# EUROPEAN PATENT SPECIFICATION

(11) **EP 3 186 822 B1**
(45) Date of publication and mention of the grant of the patent: **15.12.2021**
(21) Application number: 15836008.1
(22) Date of filing: 26.08.2015
(51) Int. Cl.: H01L 21/285, H01L 21/768, H01L 21/3105, H01L 21/321

(54) **SELECTIVE DEPOSITION WITH ALCOHOL SELECTIVE REDUCTION AND PROTECTION**
SELEKTIVE ABSCHEIDUNG MIT SELEKTIVER REDUKTION UND PASSIVIERUNG MITTELS ALKOHOL
DÉPÔT SÉLECTIF PAR RÉDUCTION ET PROTECTION SÉLECTIVES AVEC DE L'ALCOOL

(30) Priority: 27.08.2014 US 201414469980
(43) Date of publication of application: 05.07.2017
(73) Proprietor: Applied Materials, Inc., Santa Clara, CA 95054 (US)
(72) Inventor: LIU, Feng Q., San Jose, California 95129 (US); MA, Paul F., Santa Clara, California 95051 (US); AI, Hua, Tracy, CA 95304 (US); LU, Jiang, Milpitas, California 95035 (US); CHANG, Mei, Saratoga, California 95070 (US); THOMPSON, David, San Jose, California 95138 (US)
(74) Representative: Zimmermann & Partner Patentanwälte mbB
(86) International application number: PCT/US2015/046869
(87) International publication number: WO 2016/033145

(56) References cited:
- WO-A2-2007/066277
- US-A1- 2009 269 507
- US-A1- 2010 248 473
- US-A1- 2011 256 722
- US-A1- 2012 045 898
- US-A1- 2012 114 869
- US-A1- 2013 307 150
- None

## Description

### BACKGROUND

Embodiments of the disclosure generally relate to methods of selectively depositing a film. More particularly, embodiments of the disclosure are directed to methods of selectively depositing a film using alcohol selective reduction and selective protection.

As the chip feature size goes below 14nm, the leakage current of copper affects the reliability of the chip. In order to improve the reliability of the leakage current, a selective cobalt on copper capping layer is used for the integration process. In order to make the capping layer function well, the deposition on copper over dielectric might be highly selective.

In a conventional process, hydrogen at greater than 300 °C is used to reduce copper oxide to copper metal. After lowering the temperature, a silylamine derivative is used to modify the dielectric surface. This process uses a two-step pretreatment before cobalt can be deposited. The temperature difference between the two steps causes the pre-treatment process to take time. US 2009/269507 relates to a metallization process for manufacturing semiconductor devices, more particularly, to preventing copper dewetting by depositing cobalt materials on as substrate. US 2010/248473 relates to semiconductor processing and semiconductor devices, and more particularly, to methods for integrating metal-containing cap layers into copper (Cu) metallization of semiconductor devices to improve electromigration (EM) and stress migration (SM) in bulk Cu metal. US 2012/114869 relates to a film forming method for forming a film.

Therefore, there is a need in the art for methods of depositing a metal film onto a metal surface selectively over a dielectric surface.

### SUMMARY

One or more embodiments of the disclosure are directed to methods of depositing a film, as defined in claim 1. A substrate comprising a first substrate surface including a metal oxide and a second substrate surface including a dielectric is provided. The substrate is exposed to a secondary alcohol to reduce the metal oxide to a first metal and form an alkoxy-terminated dielectric surface. The substrate is exposed to one or more deposition gases to deposit a second metal film on the first metal selectively over the alkoxy-terminated dielectric surface.

Additional embodiments of the disclosure are directed to methods of depositing a film. A substrate comprising a first substrate surface including a metal oxide selected from the group consisting of copper oxide, cobalt oxide, nickel oxide and ruthenium oxide and a second substrate surface including a hydroxyl-terminated dielectric is provided. The substrate is exposed to a secondary alcohol gas to reduce the metal oxide to a first metal and form an alkoxy-terminated dielectric surface. The substrate is exposed to one or more deposition gases to deposit a second metal-containing film on the first metal selectively over the alkoxy-terminated dielectric surface.

Further embodiments of the disclosure are directed to methods of depositing a film. A substrate comprising a first substrate surface including a metal oxide selected from the group consisting of copper oxide, cobalt oxide and nickel oxide and a second substrate surface including a hydroxyl-terminated low-k dielectric surface is provided. The substrate is exposed to a gaseous secondary alcohol to reduce the metal oxide to a first metal and form an alkoxy-terminated dielectric surface. The gaseous alcohol has the general formula 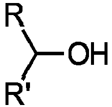 where R and R' are each independently selected from the group consisting of alkanes, alkenes, alkynes, cyclic alkanes, cyclic alkenes, cyclic alkynes and aromatics having in the range of 1 to 20 carbon atoms. The substrate is exposed to one or more deposition gases to deposit a second metal-containing film on the first metal and substantially no deposition on the alkoxy-terminated dielectric surface.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments.

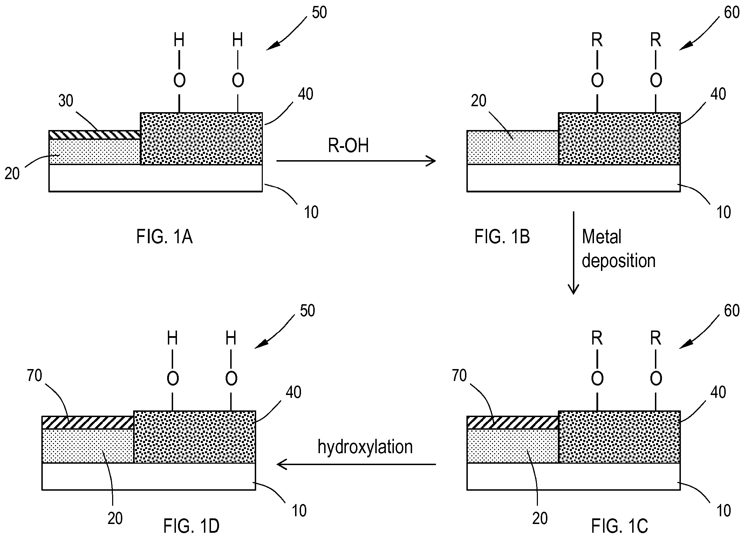

FIGS. 1A through 1D show a processing method in accordance with one or more embodiment of the disclosure.

### DETAILED DESCRIPTION

Embodiments of the disclosure provide a method of depositing a film comprising one extra pre-treatment process prior to metal deposition. Embodiments of the disclosure use a single reagent or single process step for two purposes; reducing metal oxide (e.g., copper oxide) to metal (e.g., copper) and protecting the surface of the dielectric. The single process can be performed at one process temperature. Additionally, after the metal oxide reduction and dielectric surface protection with, for example, an alkoxy group, the metal precursor has substantially no reaction with the dielectric surface. This prevents or minimizes metal deposition on the dielectric surface and improves the selectivity of the metal deposition.

As used in this specification and the appended claims, the term "substrate" and "wafer" are used interchangeably, both referring to a surface, or portion of a surface, upon which a process acts. It will also be understood by those skilled in the art that reference to a substrate can also refer to only a portion of the substrate, unless the context clearly indicates otherwise. Additionally, reference to depositing on a substrate can mean both a bare substrate and a substrate with one or more films or features deposited or formed thereon.

A "substrate" as used herein, refers to any substrate or material surface formed on a substrate upon which film processing is performed during a fabrication process. For example, a substrate surface on which processing can be performed include materials such as silicon, silicon oxide, strained silicon, silicon on insulator (SOI), carbon doped silicon oxides, silicon nitride, doped silicon, germanium, gallium arsenide, glass, sapphire, and any other materials such as metals, metal nitrides, metal alloys, and other conductive materials, depending on the application. Substrates include, without limitation, semiconductor wafers. Substrates may be exposed to a pretreatment process to polish, etch, reduce, oxidize, hydroxylate, anneal and/or bake the substrate surface. In addition to film processing directly on the surface of the substrate itself, in the present invention, any of the film processing steps disclosed may also be performed on an underlayer formed on the substrate as disclosed in more detail below, and the term "substrate surface" is intended to include such underlayer as the context indicates. Thus for example, where a film/layer or partial film/layer has been deposited onto a substrate surface, the exposed surface of the newly deposited film/layer becomes the substrate surface. What a given substrate surface comprises will depend on what films are to be deposited, as well as the particular chemistry used. In one or more embodiments, the first substrate surface will comprise a metal, and the second substrate surface will comprise a dielectric, or *vice versa.* In some embodiments, a substrate surface may comprise certain functionality (*e.g.*, -OH, -NH, etc.).

Likewise, the films that can be used in the methods described herein are quite varied. In some embodiments, the films may comprise, or consist essentially of a metal. Examples of metal films include, but are not limited to, cobalt (Co), copper (Cu), nickel (Ni), tungsten (W), etc. In some embodiments, the film comprises a dielectric. Examples include, SiO₂, SiN, HfO₂, etc.

As used in this specification and the appended claims, the terms "reactive gas", "precursor", "reactant", and the like, are used interchangeably to mean a gas that includes a species which is reactive with a substrate surface. For example, a first "reactive gas" may simply adsorb onto the surface of a substrate and be available for further chemical reaction with a second reactive gas.

One or more embodiments of the disclosure incorporate alcohol to function as a reducing agent to reduce a metal oxide (e.g., copper oxide) to metal (e.g., copper) and to function as a protecting agent to protect a dielectric surface by replacing the functional group (e.g., hydroxyl groups) with alkoxy groups. Some embodiments of the disclosure are vapor phase processes. In one or more embodiments, the process occurs at a single temperature.

After the metal oxide reduction and dielectric surface protection with alkoxy groups, a metal precursor (e.g., a cobalt precursor) has little or no reaction with the dielectric surface. With little or no reaction, the metal precursor is prevented from depositing on the dielectric surface. Therefore, one or more embodiments of the disclosure improve the selectivity of metal deposition.

In some embodiments, the process temperature is in the range of about 140 ºC to about 300 ºC. The alcohol of some embodiments is a secondary alcohol (e.g., iso-propanol, 2-butanol, 2-pentanol, 3-pentanol, 2-hexanol, 3-hexanol, cyclopentanol, cyclohexanol). Suitable alcohols can reduce the metal oxide to metal at vapor phase at process temperature. Suitable alcohols may modify the dielectric surface to replace hydroxyl groups with alkoxy groups. In one or more embodiments, the Co selective deposition on Cu over dielectric is improved.

Accordingly, one or more embodiments of the disclosure are directed to methods of depositing a film. The deposited film can be a metal film or a metal-containing film. A metal-containing film can be a metal film or a mixed metal-non-metal film, for example, a metal oxide or metal nitride film, as the context implies.

Embodiments of the disclosure provide methods of selectively depositing a metal film onto one surface over a second surface. As used in this specification and the appended claims, the term "selectively depositing a film on one surface over another surface", and the like, means that a first amount of the film is deposited on the first surface and a second amount of film is deposited on the second surface, where the second amount of film is less than the first amount of film or none. The term "over" used in this regard does not imply a physical orientation of one surface on top of another surface, rather a relationship of the thermodynamic or kinetic properties of the chemical reaction with one surface relative to the other surface. For example, selectively depositing a cobalt film onto a copper surface over a dielectric surface means that the cobalt film deposits on the copper surface and less or no cobalt film deposits on the dielectric surface; or that the formation of the cobalt film on the copper surface is thermodynamically or kinetically favorable relative to the formation of a cobalt film on the dielectric surface.

With reference to FIGS. 1A-1D, a substrate 10 is provided or placed into a processing chamber. The substrate 10 has a first surface 20 which includes a metal oxide 30 and a second surface 40. For example, the first surface and the second surface may make up a semiconductor feature (e.g., a trench) in which the first surface forms a portion of the feature (e.g., bottom of the trench) and the second surface forms a separate part of the feature (e.g., sidewalls of the trench). As can be seen from the representation of the first surface 20 in FIG. 1A, the metal oxide 30 can be any oxide coating on the first surface 20. For example, the first surface can be copper with a thin layer of coper oxide on the surface. The metal oxide 30 layer can be formed by any suitable means, either intentionally, or as a side-result of another process. For example, the oxide layer may be formed as the result of exposure to air during movement of the substrate or can be intentionally formed by exposure to an oxidizing gas (e.g., oxygen or ozone).

The metal oxide can be any suitable metal oxide. In some embodiments, the metal oxide 30 includes the metal of the first surface 20 so that upon reduction of the metal oxide, the bulk metal of the first surface remains. In some embodiments, the metal oxide of the first substrate surface comprises one or more of copper oxide, cobalt oxide, nickel oxide and ruthenium oxide.

The second surface 40 of some embodiments includes a dielectric material. In one or more embodiments, the second surface 40 comprises a dielectric material with a hydroxy-terminated surface 50. Hydroxy-terminated may also be referred to as "hydroxy-modified", and the like, to make a surface having hydroxyl groups.

The substrate 10 including the first surface 20, metal oxide 30 and second surface 40 with hydroxy-terminated surface 50 are exposed to an alcohol. As shown in FIG. 1B, the alcohol reduces the metal oxide 30 to the first surface 20 (e.g., the first metal). The reduction of the metal oxide to metal may also be referred to as reduction to a zero-valent metal. For example, copper oxide is reduced to copper.

Exposure to the alcohol also esterifies the hydroxyl-terminated surface 50 of the dielectric 40 to an alkoxy-terminated 60 second surface 40. As used in this specification and the appended claims, the term "alkoxy-terminated" means a surface with -OR groups. The term "alkoxy-terminated" and "alkoxy-modified" are used interchangeably. An alkoxy-terminated surface can have any R group depending on the alcohol used. The alkoxy group is not limited to alkanes and can be, for example, an alkane, alkene, alkyne, cycloalkane, cycloalkene, cycloalkyne, aryl (also called an aryloxy), or combinations thereof. For example, a silicon dioxide dielectric having hydroxyl terminations can be esterified with ethanol to a silicon dioxide dielectric with ethoxy terminations.

The dielectric of the second surface 40 can be any suitable dielectric. In some embodiments, the dielectric of the second surface 40 comprises a low-k dielectric. As used in this specification and the appended claims, the term low-k dielectric refers to a dielectric material having a dielectric constant less than or equal to about 5.

The alcohol can be any suitable alcohol depending on, for example, the first surface, the second surface, the deposition temperature and the final metal film being formed. The alcohol is a secondary alcohol.

Suitable secondary alcohol include, but are not limited to, 2-butanol, β-phenylethanol, diphenylmethanol, and1,2-propanediol (propylene glycol). Propylene glycol (1,2-propandiol) can act as both a primary and secondary alcohol. In one or more embodiments, the secondary alcohol is selected from the group consisting of 2-butanol, β-phenylethanol, diphenylmethanol, 1,2-propanediol (propylene glycol) and combinations thereof.

In some embodiments, the alcohol has the general formula 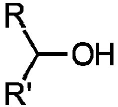 where R and R' are each independently selected from the group consisting of alkanes, alkenes, alkynes, cyclic alkanes, cyclic alkenes, cyclic alkynes and aromatics having in the range of 1 to 20 carbon atoms.

In examples outside the scope of the claims, the alcohol may be a carboxylic acid. In this case, the compound used as the alcohol is not strictly an alcohol with the formula R-OH, but contains a hydroxyl in the form of R-COOH. In some examples, the alcohol may be replaced with an aldehyde having the general formula RCOH as will be understood by those skilled in the art.

In some examples the alcohol may be a carboxylic acid having the general formula 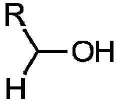 where R is selected from the group consisting of hydrogen, alkanes, alkenes, alkynes, cyclic alkanes, cyclic alkenes, cyclic alkynes and aromatics having in the range of 1 to 20 carbon atoms.

In some examples, the reducing agent may be an aldehyde instead of an alcohol, the aldehyde having the general formula 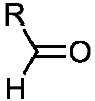 where R is selected from the group consisting of hydrogen, alkanes, alkenes, alkynes, cyclic alkanes, cyclic alkenes, cyclic alkynes and aromatics having in the range of 1 to 20 carbon atoms.

The temperature at which the alcohol, carboxylic acid or aldehyde is exposed to the substrate surfaces depends on, for example, the first surface, the second surface, the reducing agent being used (e.g., alcohol, carboxylic acid or aldehyde), the planned future processing, the past processing and the processing equipment being used. For example, a lower temperature process may help preserve the thermal budget of the substrate for further processing or the reducing agent being employed has a higher boiling point. In some embodiments, the substrate surface are exposed to the alcohol at a temperature in the range of about 140 ºC to about 300 ºC. In one or more embodiments, the substrate surfaces are exposed to the alcohol at a temperature in the range of about 180 º to about 280 ºC or in the range of about 190 º to about 270 ºC or in the range of about 200 º to about 260 ºC or in the range of about 210 º to about 250 ºC. In some embodiments, the process temperature is less than about 310 ºC, or less than about 300 ºC, or less than about 290 ºC, or less than about 280 ºC, or less than about 270 ºC, or less than about 260 ºC, or less than about 250 ºC, or less than about 240 ºC. In some embodiments, the exposure to the reducing agent occurs in the vapor phase.

After exposure to the reducing agent , the metal oxide film on the first surface has been reduced to the first metal and the second surface (e.g., dielectric) has been protected. This enables a metal film or metal-containing film to be deposited onto the first metal of the first surface selectively over deposition onto the second surface. The metal film can be deposited by any suitable method (e.g., atomic layer deposition, chemical vapor deposition).

Referring to the change from FIG. 1B. to FIG. 1C, after protecting the second surface 40 and preparing the first surface 20 (i.e., removing the oxide layer) the substrate surfaces can be exposed to one or more deposition gases to deposit a second metal 70, or second metal-containing film, onto the first surface 20. This deposition can occur selectively on surface 20 over the alkoxy-terminated 60 second surface 40, or the protected second surface 40.

Any suitable metal can be deposited as the second metal or metal-containing film. In some embodiments, the metal film comprises one or more of cobalt, copper, nickel, tungsten and ruthenium. For example, a cobalt film may be deposited over copper with substantially no deposition on a protected dielectric. As used in this specification and the appended claims, the term "substantially no deposition" used in this regard means that deposition thickness ratio of deposited layer 70 on surface 60 over on surface 20, in a ratio range of 0-0.1, or 0-0.01.

In some embodiments, the first surface 20 comprises copper and the second metal 70 comprises cobalt. In one or more embodiments, the one or more deposition gases used to deposit the second metal 70 is one or more of cyclopentadienylcobalt dicarbonyl (CpCoCO), dicobalt hexacarbonyl tert-butylacetylene (CCTBA). bis(2,2,6,6-tetramethyl-3,5-heptaneketoiminate)cobalt, bis(dimethylamino-2-propoxy)copper, bis(dimethylamino-2-ethoxy)copper, bis(dimethylamino-2-propoxy)Nickel and/or bis(2,2,6,6-tetramethyl-3,5-heptaneketoiminate)nickel.

In one or more embodiments, the first surface 20 comprises cobalt and the second metal 70 comprises copper. In some embodiments, the first surface 20 comprises nickel and the second metal 70 comprises one or more of copper and cobalt.

Once the second metal 70 has been deposited, further processing may be performed. For example, with reference to FIGS. 1C and 1D, hydroxylation of the alkoxy-terminated 60 second surface 40 may occur. This can be done by any suitable method or technique that can remove the alkoxy terminations from the alkoxy-terminated dielectric surface after depositing the second metal film such as water vapor.

In some embodiments, the process occurs in a batch processing chamber. For example, in a rotating platen chamber, one or more wafers are placed on a rotating holder ("platen"). As the platen rotates, the wafers move between various processing areas. For example, in ALD, the processing areas would expose the wafer to precursor and reactants. In addition, plasma exposure may be useful to properly treat the film or the surface for enhanced film growth, or to obtain desirable film properties.

Some embodiments of the disclosure process a substrate with the first surface and the second surface in a single processing chamber where in a first portion of the chamber, the substrate surfaces are exposed to the reducing agent (e.g., alcohol) to reduce the metal oxide and protect the second surface. The substrate is rotated to a second portion, or second and subsequent third portion or more, of the processing chamber to deposit the metal film on the first metal surface. In some embodiments, the substrate can be further rotated or moved to another portion of the processing chamber where the alkoxy-terminations of the second surface can be removed. To separate each or any of the portions, or regions, of the processing chamber, a gas curtain can be employed. The gas curtain provides one or more of purge gas and vacuum ports between the processing regions to prevent reactive gases from moving from one region to an adjacent region. In some embodiments, the substrate is exposed to more than one processing region at the same time, with one portion of the substrate in a first region (e.g., for alcohol exposure) and another portion of the substrate at the same time being in a separate region (e.g., metal deposition) of the processing chamber.

Embodiments of the disclosure can be used with either a linear processing system or a rotational processing system. In a linear processing system, the width of the area that the plasma exits the housing is substantially the same across the entire length of front face. In a rotational processing system, the housing may be generally "pie-shaped" or "wedge-shaped". In a wedge-shaped segment, the width of the area that the plasma exits the housing changes to conform to a pie shape. As used in this specification and the appended claims, the terms "pie-shaped" and "wedge-shaped" are used interchangeably to describe a body that is a generally circular sector. For example, a wedge-shaped segment may be a fraction of a circle or disc-shaped object. The inner edge of the pie-shaped segment can come to a point or can be truncated to a flat edge or rounded. The path of the substrates can be perpendicular to the gas ports. In some embodiments, each of the gas injector assemblies comprise a plurality of elongate gas ports which extend in a direction substantially perpendicular to the path traversed by a substrate. As used in this specification and the appended claims, the term "substantially perpendicular" means that the general direction of movement of the substrates is along a plane approximately perpendicular (e.g., about 45º to 90º) to the axis of the gas ports. For a wedge-shaped gas port, the axis of the gas port can be considered to be a line defined as the mid-point of the width of the port extending along the length of the port.

Additional embodiments of the disclosure are directed to methods of processing a plurality of substrates. The plurality of substrates is loaded onto substrate support in a processing chamber. The substrate support is rotated to pass each of the plurality of substrates across a gas distribution assembly to expose the substrate surface to the reducing agent (e.g., alcohol), deposit a film on the substrate and, optionally, remove the protection layer from the reducing agent exposure. Any of the process steps, reducing agent exposure, metal deposition or hydroxylation can be repeated before moving to the next process, or sequentially.

Rotation of the carousel can be continuous or discontinuous. In continuous processing, the wafers are constantly rotating so that they are exposed to each of the injectors in turn. In discontinuous processing, the wafers can be moved to the injector region and stopped, and then to the region between the injectors and stopped. For example, the carousel can rotate so that the wafers move from an inter-injector region across the injector (or stop adjacent the injector) and on to the next inter-injector region where the carousel can pause again. Pausing between the injectors may provide time for additional processing between each layer deposition (e.g., exposure to plasma). The frequency of the plasma may be tuned depending on the specific reactive species being used. Suitable frequencies include, but are not limited to, 400 kHz, 2 MHz, 13.56 MHz, 27 MHz, 40 MHz, 60 MHz and 100 MHz.

According to one or more embodiments, the substrate is subjected to processing prior to and/or after forming the layer. This processing can be performed in the same chamber or in one or more separate processing chambers. In some embodiments, the substrate is moved from the first chamber to a separate, second chamber for further processing. The substrate can be moved directly from the first chamber to the separate processing chamber, or the substrate can be moved from the first chamber to one or more transfer chambers, and then moved to the separate processing chamber. Accordingly, the processing apparatus may comprise multiple chambers in communication with a transfer station. An apparatus of this sort may be referred to as a "cluster tool" or "clustered system", and the like.

Generally, a cluster tool is a modular system comprising multiple chambers which perform various functions including substrate center-finding and orientation, degassing, annealing, deposition and/or etching. According to one or more embodiments, a cluster tool includes at least a first chamber and a central transfer chamber. The central transfer chamber may house a robot that can shuttle substrates between and among processing chambers and load lock chambers. The transfer chamber is typically maintained at a vacuum condition and provides an intermediate stage for shuttling substrates from one chamber to another and/or to a load lock chamber positioned at a front end of the cluster tool. Two well-known cluster tools which may be adapted for the present disclosure are the Centura^{®} and the Endura^{®}, both available from Applied Materials, Inc., of Santa Clara, Calif. The details of one such staged-vacuum substrate processing apparatus are disclosed in U.S. Pat. No. 5,186,718, entitled "Staged-Vacuum Wafer Processing Apparatus and Method," Tepman et al., issued on Feb. 16, 1993. However, the exact arrangement and combination of chambers may be altered for purposes of performing specific steps of a process as described herein. Other processing chambers which may be used include, but are not limited to, cyclical layer deposition (CLD), atomic layer deposition (ALD), chemical vapor deposition (CVD), physical vapor deposition (PVD), etch, preclean, chemical clean, thermal treatment such as RTP, plasma nitridation, degas, orientation, hydroxylation and other substrate processes. By carrying out processes in a chamber on a cluster tool, surface contamination of the substrate with atmospheric impurities can be avoided without oxidation prior to depositing a subsequent film.

According to one or more embodiments, the substrate is continuously under vacuum or "load lock" conditions, and is not exposed to ambient air when being moved from one chamber to the next. The transfer chambers are thus under vacuum and are "pumped down" under vacuum pressure. Inert gases may be present in the processing chambers or the transfer chambers. In some embodiments, an inert gas is used as a purge gas to remove some or all of the reactants after forming the layer on the surface of the substrate. According to one or more embodiments, a purge gas is injected at the exit of the deposition chamber to prevent reactants from moving from the deposition chamber to the transfer chamber and/or additional processing chamber. Thus, the flow of inert gas forms a curtain at the exit of the chamber.

During processing, the substrate can be heated or cooled. Such heating or cooling can be accomplished by any suitable means including, but not limited to, changing the temperature of the substrate support (e.g., susceptor) and flowing heated or cooled gases to the substrate surface. In some embodiments, the substrate support includes a heater/cooler which can be controlled to change the substrate temperature conductively. In one or more embodiments, the gases (either reactive gases or inert gases) being employed are heated or cooled to locally change the substrate temperature. In some embodiments, a heater/cooler is positioned within the chamber adjacent the substrate surface to convectively change the substrate temperature.

The substrate can also be stationary or rotated during processing. A rotating substrate can be rotated continuously or in discreet steps. For example, a substrate may be rotated throughout the entire process, or the substrate can be rotated by a small amount between exposure to different reactive or purge gases. Rotating the substrate during processing (either continuously or in steps) may help produce a more uniform deposition or etch by minimizing the effect of, for example, local variability in gas flow geometries.

While the foregoing is directed to embodiments of the present disclosure, other and further embodiments of the disclosure may be devised without departing from the basic scope thereof, and the scope thereof is determined by the claims that follow.

## Claims

1. A method of depositing a film, the method comprising:
providing a substrate comprising a first substrate surface including a metal oxide and a second substrate surface including a dielectric;
exposing the substrate to an alcohol to reduce the metal oxide to a first metal and form an alkoxy-terminated dielectric surface; and
exposing to the substrate to one or more deposition gases to deposit a second metal film on the first metal selectively over the alkoxy-terminated dielectric surface, wherein the alcohol is a secondary alcohol.

2. The method of claim 1, wherein the metal oxide of the first substrate surface comprises one or more of copper oxide, cobalt oxide, nickel oxide and ruthenium oxide.

3. The method of claim 1, wherein the metal oxide of the first substrate surface comprises copper oxide and the first metal comprises copper.

4. The method of claim 1, wherein the dielectric comprises hydroxyl terminations.

5. The method of claim 1, wherein the dielectric is a low-k dielectric.

6. The method of claim 1, wherein the alcohol is selected from the group consisting 2-butanol, β-phenylethanol, Diphenylmethanol, 1,2-propanediol (propylene glycol) and combinations thereof.

7. The method of claim 1, wherein the metal film comprises one or more of cobalt, copper, nickel and tungsten.

8. The method of claim 1, wherein the alcohol has the general formula 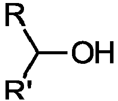 Where R and R' are each independently selected from the group consisting of alkanes, alkenes, alkynes, cyclic alkanes, cyclic alkenes, cyclic alkynes and aromatics having in the range of 1 to 20 carbon atoms.

9. The method of claim 1, wherein the one or more deposition gases to deposit the second metal film comprises one or more of cyclopentadienylcobalt dicarbonyl (CpCoCO), dicobalt hexacarbonyl tert-butylacetylene (CCTBA), bis(2,2,6,6-tetramethyl-3,5-heptaneketoiminate)cobalt, bis(dimethylamino-2-propoxy)copper, bis(dimethylamino-2-ethoxy)copper or bis(dimethylamino-2-propoxy)nickel, bis(2,2,6,6-tetramethyl-3,5-heptaneketoiminate)nickel.

10. The method of claim 1, wherein substantially none of the second metal film deposits on the alkoxy-terminated dielectric surface.

11. The method of claim 1, further comprising removing the alkoxy terminations from the alkoxy-terminated dielectric surface after depositing the second metal film.

## Patentansprüche

1. Verfahren zum Abscheiden einer Schicht, das Verfahren umfassend:
Bereitstellen eines Substrats, umfassend eine erste Substratoberfläche, die ein Metalloxid aufweist, und eine zweite Substratoberfläche, die ein Dielektrikum aufweist;
Aussetzen des Substrats gegenüber einem Alkohol zum Reduzieren des Metalloxids zu einem ersten Metall und zum Bilden einer alkoxyterm inierten dielektrischen Oberfläche; und
Aussetzen des Substrats gegenüber einem oder mehreren Abscheidungsgasen zum selektiven Abscheiden einer zweiten Metallschicht auf dem ersten Metall über der alkoxyterm inierten dielektrischen Oberfläche, wobei der Alkohol ein sekundärer Alkohol ist.

2. Verfahren nach Anspruch 1, wobei das Metalloxid der ersten Substratoberfläche eines oder mehrere von Kupferoxid, Kobaltoxid, Nickeloxid und Rutheniumoxid umfasst.

3. Verfahren nach Anspruch 1, wobei das Metalloxid der ersten Substratoberfläche Kupferoxid umfasst und das erste Metall Kupfer umfasst.

4. Verfahren nach Anspruch 1, wobei das Dielektrikum Hydroxyl-Endgruppen umfasst.

5. Verfahren nach Anspruch 1, wobei das Dielektrikum ein Low-k-Dielektrikum ist.

6. Verfahren nach Anspruch 1, wobei der Alkohol ausgewählt ist aus der Gruppe bestehend aus 2-Butanol, β-Phenylethanol, Diphenylmethanol, 1,2-Propandiol (Propylenglykol) und Kombinationen davon.

7. Verfahren nach Anspruch 1, wobei die Metallschicht eines oder mehrere von Kobalt, Kupfer, Nickel und Wolfram umfasst.

8. Verfahren nach Anspruch 1, wobei der Alkohol folgende allgemeine Formel aufweist 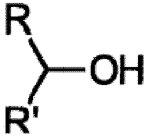 wobei R und R' jeweils unabhängig ausgewählt sind aus der Gruppe bestehend aus Alkanen, Alkenen, Alkinen, cyclischen Alkanen, cyclischen Alkenen, cyclischen Alkinen und Aromaten, die im Bereich von 1 bis 20 Kohlenstoffatome aufweisen.

9. Verfahren nach Anspruch 1, wobei das eine oder die mehreren Abscheidungsgase zum Abscheiden der zweiten Metallschicht eines oder mehrere von Cyclopentadienylcobaltdicarbonyl (CpCoCO), Dicobalthexacarbonyl-tert-butylacetylen (CCTBA), Bis-(2,2,6,6-tetramethyl-3,5-heptaneketoiminat)-Kobalt, Bis-(dimethylamino-2-propoxy)-Kupfer, Bis-(dimethylamino-2-ethoxy)-Kupfer oder Bis-(dimethylamino-2-propoxy)-Nickel, Bis-(2,2,6,6-tetramethyl-3,5-heptaneketoiminat)-Nickel umfasst.

10. Verfahren nach Anspruch 1, wobei sich im Wesentlichen keine zweite Metallschicht auf der alkoxyterminierten dielektrischen Oberfläche abscheidet.

11. Verfahren nach Anspruch 1, ferner umfassend das Entfernen der Alkoxy-Endgruppen von der alkoxyterminierten dielektrischen Oberfläche nach dem Abscheiden der zweiten Metallschicht.

## Revendications

1. Procédé de déposition d'un film, le procédé comprenant :
l'obtention d'un substrat comprenant une première surface de substrat contenant un oxyde métallique et une deuxième surface de substrat contenant un diélectrique ;
l'exposition du substrat à un alcool pour réduire l'oxyde métallique en un premier métal et former une surface de diélectrique à terminaison alcoxy ; et
l'exposition du substrat à un ou plusieurs gaz de déposition pour déposer un deuxième film métallique sur le premier métal sélectivement sur la surface de diélectrique à terminaison alcoxy,
dans lequel l'alcool est un alcool secondaire.

2. Procédé selon la revendication 1, dans lequel l'oxyde métallique de la première surface de substrat comprend un ou plusieurs parmi l'oxyde de cuivre, l'oxyde de cobalt, l'oxyde de nickel et l'oxyde de ruthénium.

3. Procédé selon la revendication 1, dans lequel l'oxyde métallique de la première surface de substrat comprend de l'oxyde de cuivre et le premier métal comprend du cuivre.

4. Procédé selon la revendication 1, dans lequel le diélectrique comprend des terminaisons hydroxyle.

5. Procédé selon la revendication 1, dans lequel le diélectrique est un diélectrique à faible valeur k.

6. Procédé selon la revendication 1, dans lequel l'alcool est choisi dans le groupe constitué par le 2-butanol, le β-phényléthanol, le diphénylméthanol, le 1,2-propanediol (propylèneglycol) et leurs combinaisons.

7. Procédé selon la revendication 1, dans lequel le film métallique comprend un ou plusieurs parmi le cobalt, le cuivre, le nickel et le tungstène.

8. selon la revendication 1, dans lequel l'alcool est de formule générale 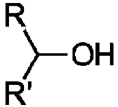 dans laquelle R et R' sont chacun indépendamment choisis dans le groupe constitué par les alcanes, les alcènes, les alcynes, les alcanes cycliques, les alcènes cycliques, les alcynes cycliques et les aromatiques ayant de 1 à 20 atomes de carbone.

9. Procédé selon la revendication 1, dans lequel le ou les gaz de déposition pour déposer le deuxième film métallique comprennent un ou plusieurs parmi le cyclopentadiényl-cobalt dicarbonyle (CpCoCO), le dicobalt-hexacarbonyl-tert-butylacétylène (CCTBA), le bis(2,2,6,6-tétraméthyl-3,5-heptanecétoiminate)cobalt, le bis(diméthylamino-2-propoxy)cuivre, le bis(diméthylamino-2-éthoxy)cuivre ou bis(diméthylamino-2-propoxy)nickel, le bis(2,2,6,6-tétraméthyl-3,5-heptanecétoiminate)nickel.

10. Procédé selon la revendication 1, dans lequel pratiquement rien du deuxième film métallique ne se dépose sur la surface de diélectrique à terminaison alcoxy.

11. Procédé selon la revendication 1, comprenant en outre l'élimination des terminaisons alcoxy sur la surface de diélectrique à terminaison alcoxy après la déposition du deuxième film métallique.
